# EUROPÄISCHE PATENTSCHRIFT

(11) **EP 4 237 813 B1**
(45) Veröffentlichungstag und Bekanntmachung des Hinweises auf die Patenterteilung: **01.04.2026**
(21) Anmeldenummer: 21778366.1
(22) Anmeldetag: 13.09.2021
(51) Int. Cl.: G01M 5/00, B23K 1/00, G01R 31/50, G01R 31/54, H05K 3/34, C22C 13/02, B23K 37/006, B23K 101/42

(54) **ELEKTRONISCHES GERÄT UND VERFAHREN ZUM FESTSTELLEN EINER MECHANISCHEN ÜBERBEANSPRUCHUNG EINES ELEKTRONISCHEN GERÄTS**
ELECTRONIC DEVICE AND METHOD FOR DETERMINING MECHANICAL OVERSTRESS OF AN ELECTRONIC DEVICE
DISPOSITIF ELECTRONIQUE ET PROCEDE POUR DETERMINER LA SURTENSION MECANIQUE D'UN DISPOSITIF ELECTRONIQUE

(30) Priorität: 29.10.2020 DE 102020128470
(43) Veröffentlichungstag der Anmeldung: 06.09.2023
(73) Patentinhaber: Endress+Hauser SE+Co. KG, 79689 Maulburg (DE)
(72) Erfinder: BIRGEL, Dietmar, 79650 Schopfheim (DE); STRÜTT, Bernd, 79585 Steinen (DE); CZAJA, Silke, 79650 Schopfheim (DE)
(74) Vertreter: Endress + Hauser Group Services (Deutschland) AG+Co. KG
(86) Internationale Anmeldenummer: PCT/EP2021/075126
(87) Internationale Veröffentlichungsnummer: WO 2022/089824

(56) Entgegenhaltungen:
- DE-A1- 102018 128 063
- US-A- 5 368 814
- US-A1- 2006 191 889
- US-A1- 2008 144 243
- HUAKANG LI ET AL: "Mechanism of Solder Joint Intermittent Faults and Its Detection", 2018 IEEE INTERNATIONAL SYMPOSIUM ON THE PHYSICAL AND FAILURE ANALYSIS OF INTEGRATED CIRCUITS (IPFA), IEEE, 16 July 2018 (2018-07-16), pages 1 - 5, XP033397025, DOI: 10.1109/IPFA.2018.8452542
- KIM Y S ET AL: "Effect of composition and cooling rate on microstructure and tensile properties of Sn-Zn-Bi alloys", JOURNAL OF ALLOYS AND COMPOUNDS, ELSEVIER SEQUOIA, LAUSANNE, CH, vol. 352, no. 1-2, 24 March 2003 (2003-03-24), pages 237 - 245, XP004416945, ISSN: 0925-8388, DOI: 10.1016/S0925-8388(02)01168-4
- XU KAI-KAI ET AL: "Review of microstructure and properties of low temperature lead-free solder in electronic packaging", SCIENCE AND TECHNOLOGY OF ADVANCED MATERIALS, vol. 21, no. 1, 31 January 2020 (2020-01-31), pages 689 - 711, XP055907077, ISSN: 1468-6996, DOI: 10.1080/14686996.2020.1824255

## Beschreibung

Die Erfindung betrifft ein elektronisches Gerät aufweisend eine Schaltungsanordnung. Ferner betrifft die Erfindung ein Verfahren zum Feststellen einer mechanischen Überbeanspruchung eines elektronischen Geräts.

Bei dem elektronischen Gerät handelt es sich insbesondere um ein Feldgerät der Automatisierungstechnik. Feldgeräte der Automatisierungstechnik werden zur Bestimmung und/oder Überwachung von Prozessgrößen eingesetzt. Als Feldgeräte werden dabei im Prinzip alle Geräte bezeichnet, die prozessnah eingesetzt werden und prozessrelevante Informationen liefern oder verarbeiten. Dabei handelt es sich beispielsweise um Füllstandsmessgeräte, Durchflussmessgeräte, Druck- und Temperaturmessgeräte, pH-Redoxpotentialmessgeräte, Leitfähigkeitsmessgeräte, usw., welche die entsprechenden Prozessgrößen Füllstand, Durchfluss, Druck, Temperatur, pH-Wert bzw. Leitfähigkeit erfassen. Feldgeräte weisen oftmals eine, insbesondere zumindest zeitweise und/oder zumindest abschnittsweise mit einem Prozessmedium in Kontakt stehende Sensoreinheit auf, welche der Erzeugung eines von der Prozessgröße abhängigen Signals dient. Ferner weisen diese oftmals zumindest eine in einem Gehäuse angeordnete Elektronikeinheit mit einer Schaltungsanordnung auf, wobei die Elektronikeinheit typischerweise der Verarbeitung und/oder Weiterleitung von von der Sensoreinheit erzeugten Signalen, insbesondere elektrischen und/oder elektronischen Signalen, dient.

Prozessnah eingesetzte elektronische Geräte wie etwa die vorstehend genannten Feldgeräte sind dabei typischerweise mitunter harschen Einsatzbedingungen ausgesetzt. Hierzu zählen insbesondere auch mechanischen Beanspruchungen, bspw. Vibrationen, Schläge und/oder durch schnelle Temperaturwechsel hervorgerufene thermomechanische Beanspruchungen. Der Hersteller des elektronischen Geräts spezifiziert daher in der Regel, soweit möglich, eine bei einem bestimmungsgemäßen Einsatz maximale mechanische Beanspruchung, unter denen das ausfallsichere Betreiben des elektronischen Geräts garantierbar bzw. sicherstellbar ist. Bei einem Schadensfall erweist sich ein Nachweis darüber, dass das elektronische Gerät, insb. höchstens zeitweise, zu stark mechanisch beansprucht wurde, als anspruchsvoll, insb. im Nachhinein. Ein für die Erfindung relevantes Dokument aus dem Stand der Technik ist Huakang Li et al.: "Mechanism of Solder Joint Intermittent Faults and Its Detection", 2018 IEEE INTERNATIONAL SYMPOSIUM ON THE PHYSICAL AND FAILURE ANALYSIS OF INTEGRATED CIRCUITS (IPFA), IEEE, 16. Juli 2018, Seiten 1-5, DOI: 10.1109/IPFA.2018.8452542.

Der Erfindung liegt daher die Aufgabe zugrunde, ein elektronisches Gerät anzugeben, dessen zeitweilige mechanische Überbeanspruchung in einem Messbetrieb möglichst einfach feststellbar ist.

Die Aufgabe wird gelöst durch ein elektronisches Gerät gemäß Ansprüchen 1-9 und ein Verfahren zum Feststellen einer mechanischen Überbeanspruchung eines elektronischen Geräts gemäß Ansprüchen 10-13.

Bezüglich des elektronischen Geräts wird die Aufgabe gelöst durch ein elektronisches Gerät aufweisend eine Schaltungsanordnung, wobei die Schaltungsanordnung in einem elektrisch leitenden Pfad der Schaltungsanordnung eine sprödbrechende Lotverbindung aufweist, und wobei die Schaltungsanordnung dazu ausgestaltet ist, einen höchstens zeitweiligen Spannungs- und/oder Stromunterbruch in dem Pfad zu detektieren und einem höchstens teilweisen Sprödbruch der sprödbrechenden Lotverbindung zuzuordnen, welcher Sprödbruch durch eine höchstens zeitweilige mechanische Überbeanspruchung des elektronischen Geräts verursacht ist, so dass anhand der Schaltungsanordnung die höchstens zeitweilige mechanische Überbeanspruchung des elektronischen Geräts feststellbar ist.

Gemäß der Erfindung ist vorteilhaft nur anhand der Schaltungsanordnung des elektronischen Geräts selbst, d.h. ohne den Einsatz zusätzlicher Vibrations- und/oder Schlagsensoren dessen zeitweilige mechanische Überbeanspruchung feststellbar. Dies wird dadurch erreicht, dass eine, insb. zumindest eine, Lotverbindung der Schaltungsanordnung als sprödbrechend ausgebildet ist.

In der Werkstoffmechanik werden Werkstoffe anhand ihrer Bruchmechanik als spröde oder als duktil brechend klassifiziert. Sprödbrechende (auch: spröde) Werkstoffe zeichnen sich unter mechanischer Beanspruchung im Spannungs-Dehnungs-Diagramm durch einen steilen Anstieg der Hook'schen Geraden aus, an deren Ende ein Bruch ohne plastische Deformation erfolgt. Zusätzlich zu diesem charakteristischen Verhalten ist ein Sprödbruch i.d.R. auch im Nachhinein als solcher erkennbar, etwa durch entsprechende werkstoffmechanische Untersuchungen an den Bruchflächen.

Unter der zeitweiligen mechanischen Überbeanspruchung erfährt die Lotverbindung einen teilweisen Sprödbruch. Dadurch wird ein durch die Lotverbindung mitbestimmter Übergangswiderstand in der Schaltungsanordnung zeitweilig merklich derart erhöht, dass ein Spannung- und/oder Stromunterbruch durch die Schaltungsanordnung selbst feststellbar ist.

Da die Lotverbindung nur teilweise sprödgebrochen ist (sprich: bereichsweise, d.h. insbesondere nicht vollständig von einem Riss durchzogen ist) stehen nach der höchstens zeitweisen mechanischen Überbeanspruchung die typischerweise glatten Bruchflächen des teilweisen Sprödbruchs wieder in einem engen mechanischen Kontakt miteinander. Dadurch kommt es ggf. wieder zu einer Neuverbindung der Bruchflächen des sprödgebrochenen Bereichs der Lotverbindung, ähnlich zu einer Kaltverschweißung.

In diesem Fall normalisiert sich der durch die Lotverbindung mitbestimmte Übergangswiderstand nach der zeitweiligen Überbeanspruchung wieder auf einen Normalwert (d.h. einem Wert für den Übergangswiderstand vor dem Auftreten der Überbeanspruchung). In diesem Sinne lässt sich der teilweise Sprödbruch daher auch als reversibel bezeichnen. Im Falle eines derartigen reversiblen Sprödbruchereignis in der Lotverbindung ist nicht nur eine einmalige, sondern auch mehrmalig auftretende mechanische Überbeanspruchung feststellbar.

In einer Ausgestaltung der Erfindung ist die sprödbrechende Lotverbindung mittels eines Lötprozesses umfassend die folgenden Schritte hergestellt:
- Bereitstellen von Lot, welches Lot Bismut mit einem Anteil von zumindest 50 Gewichtsprozent aufweist;
- Aufschmelzen des Lots, bei welchem Aufschmelzen das Lot auf eine maximale Temperatur gebracht wird;
- Anschließendes Abkühlen des Lots, bei welchem Abkühlen das Lot erstarrt, so dass die Lotverbindung gebildet wird, wobei das Abkühlen mit einer Abkühlrate erfolgt, welche Abkühlrate größer als 6° C/s ist.

Untersuchungen der Anmelderin haben gezeigt, dass eine derartig hergestellte Lotverbindung überraschenderweise die sprödbrechenden Eigenschaften aufweist. Maßgeblich hierfür ist der hohe Bismutgehalt, gepaart mit den raschen Abkühlraten größer als 6° C/s.

Das Lot wird insbesondere mittels einer Lotpaste bereitgestellt.

In einer Ausgestaltung der Erfindung weist das bereitgestellte Lot Zinn mit einem Anteil von zumindest 40 Gewichtsprozent auf und/oder Silber mit einem Anteil von höchstens 2 Gewichtsprozent.

In einer Ausgestaltung der Erfindung ist die Abkühlrate größer als 10° C/s und insbesondere kleiner als 50°C/s.

Im Zusammenhang mit dem Herstellungsverfahren zur Herstellung der sprödbrechenden Lotverbindung sei auf die bei Einreichung dieser Anmeldung noch unveröffentlichte Patentanmeldung mit der Anmeldenummer 102020105180.8 verwiesen, auf dessen Offenbarungsgehalt für das Herstellen der sprödbrechenden Lotverbindung hier Bezug genommen wird.

In einer Ausgestaltung der Erfindung weist die Schaltungsanordnung zur Detektion des höchstens zeitweiligen Spannungs- und/oder Stromunterbruchs zumindest ein Komparatorelement auf.

In einer Ausgestaltung der Erfindung weist die Schaltungsanordnung einen Mikrokontroller auf, welcher Mikrokontroller derart mit dem/den Komparatorelement/en verschaltet ist, dass das/die Komparatorelement/e einen detektierten, höchstens zeitweiligen Spannungs- und/oder Stromunterbruch an den Mikrokontroller übermittelt/en.

Mittels des Mikrokontrollers kann somit die Anzahl der höchstens zeitweiligen Spannungs- und/oder Stromunterbrüche, die der mechanischen Überbeanspruchung zuordenbar sind, erfasst und ggf. auch gespeichert werden, bspw. in einem Speicherbaustein des Mikrokontrollers und/oder in einer mit dem Mikrokontroller über eine Kommunikationsverbindung verbundenen Speichereinheit.

In einer Ausgestaltung der Erfindung weist die Schaltungsanordnung einen Kondensator auf, der für den Fall eines höchstens zeitweiligen Spannungs- und/oder Stromunterbruchs für die Zeitspanne des Unterbruchs zur Überbrückung des Unterbruchs eine in dem Kondensator gespeicherte Spannung als Betriebsspannung für das elektronische Gerät bereitstellt.

Der Kondensator stellt also einen Energiespeicher dar, mittels dessen der höchstens zeitweilige Spannungs- und/oder Stromunterbruchs kompensiert wird. Der Kondensator wird dabei bspw. in einem Normalbetrieb des elektronischen Geräts aufgeladen, d.h. vor dem und anschließend zu dem Spannungs- und/oder Stromunterbruchs. Die Überbeanspruchung kann somit durch die Schaltungsanordnung erfasst werden, ohne dass die Verfügbarkeit des elektronischen Geräts für die Dauer des Unterbruchs eingeschränkt wäre.

In einer Ausgestaltung der Erfindung liegt der höchstens zeitweilige Spannungs- und/oder Stromunterbruch für eine Dauer von zumindest 3,5 ns (Nanosekunden) vor. Moderne Schaltungsanordnungen sind in der Lage, Unterbrüche von zumindest 3,5 ns zu detektieren.

In einer Ausgestaltung der Erfindung liegt der höchstens zeitweilige Spannungs- und/oder Stromunterbruchs für eine Dauer von maximal 20 ms (Millisekunden) vor.

In einer Ausgestaltung der Erfindung handelt es sich um bei dem elektronischen Gerät um ein Feldgerät der Automatisierungstechnik mit zumindest einer Elektronikeinheit, wobei die Elektronikeinheit die Schaltungsanordnung aufweist.

Bezüglich des Verfahrens wird die Aufgabe gelöst durch ein Verfahren zum Feststellen einer mechanischen Überbeanspruchung eines erfindungsgemäßen elektronischen Geräts,
umfassend den Schritt:
- Feststellen einer höchstens zeitweiligen mechanischen Überbeanspruchung des elektronischen Geräts, für den Fall, dass eine höchstens zeitweiliger Spannungs- und/oder Stromunterbruch in einem Pfad der Schaltungsanordnung detektiert wird, der einem höchstens teilweisen Sprödbruch der sprödbrechenden Lotverbindung zuordenbar ist.

In einer Ausgestaltung des Verfahrens umfasst dieses den Schritt:
- Erfassen eines Zeitpunkts, an welchem die Überbeanspruchung festgestellt wird;
- Abspeichern einer festgestellten Überbeanspruchung zusammen mit einem Zeitstempel, welcher Zeitstempel den erfassten Zeitpunkt der Überbeanspruchung markiert.

Das Feststellen der Überbeanspruchung wird bspw. in dem vorstehend genannten Speicherbaustein des Mikrokontrollers oder der Speichereinheit abgespeichert. Durch Auslesen des gespeicherten Zeitstempels ist vorteilhaft der Zeitpunkt der mechanischen Überbeanspruchung auslesbar, auch im Nachhinein bspw. bei der Abwickelung von Retouren des elektronischen Geräts.

In einer Ausgestaltung des Verfahrens wird die mechanische Überbeanspruchung wiederkehrend festgestellt und abgespeichert.

In einer Ausgestaltung des Verfahrens umfasst dieses den Schritt:
Erstellen und/oder Anpassen einer Lebensdauervorhersage für das elektronische Gerät, basierend auf der/den festgestellten mechanischen Überbeanspruchung/en.

In einer Ausgestaltung des Verfahrens wird bei der Lebensdauervorhersage zumindest eines der folgenden berücksichtigt:
- eine Anzahl der festgestellten mechanischen Überbeanspruchungen;
- den/die Zeitpunkt/e der festgestellten mechanischen Überbeanspruchung/en.

Die Erfindung sowie weitere vorteilhafte Ausgestaltungen werden nachfolgend anhand von Ausführungsbeispielen näher erläutert. Gleiche Teile sind in allen Figuren mit denselben Bezugszeichen versehen; wenn es die Übersichtlichkeit erfordert oder es anderweitig sinnvoll erscheint, wird auf bereits erwähnte Bezugszeichen in nachfolgenden Figuren verzichtet.

Es zeigen:
Fig. 1 a, b: Detailansicht einer Ausgestaltung einer Elektronikeinheit eines erfindungsgemäßen elektronischen Geräts mit einer zumindest teilweise sprödbrechenden Lotverbindung;
Fig. 2: Abkühlrate beim Herstellen der zumindest teilweise sprödbrechenden Lotverbindung;
Fig. 3: Detailansicht einer Ausgestaltungen einer Elektronikeinheit eines erfindungsgemäßen elektronischen Geräts mit einer zumindest teilweise sprödbrechenden Lotverbindung unter einer zeitweisen mechanischen Überbeanspruchung;
Fig. 4: Ein Schaltbild in einer Ausgestaltung der Erfindung;
Fig. 5: Ein Flussdiagramm für eine Ausgestaltung der erfindungsgemäßen Verfahrens;
Fig. 6: Eine Ausgestaltung eines erfindungsgemäßen elektronischen Gerät als Feldgerät der Automatisierungstechnik.

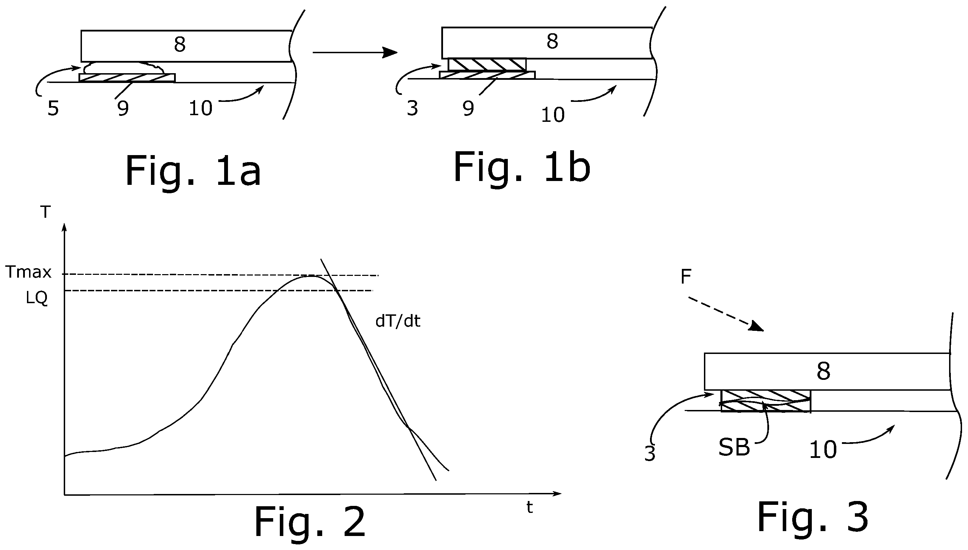

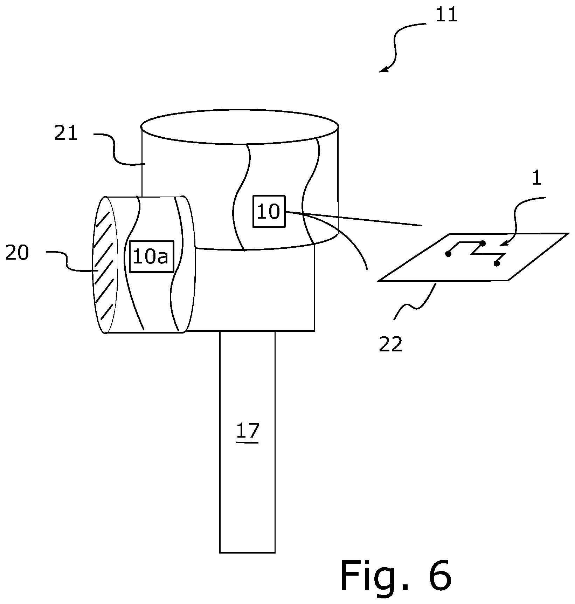

In Fig 1a,1b sind Schritte des Herstellungsverfahrens zur Herstellung einer sprödbrechenden Lotverbindung 3 zwischen einer Kontaktfläche 9 einer Leiterplatte einer Elektronikeinheit 10 und einem auf der Kontaktfläche 9 angeordneten Bauelement 8 dargestellt, wobei die Leiterplatte in einer Schnittansicht dargestellt ist. Die Elektronikeinheit 10 ist Teil eines elektronischen Geräts 11 und weist eine Schaltungsanordnung 1 (vgl. Fig. 6) auf. Das Bauelement 8 wird auf die Kontaktfläche 9 bestückt. Anschließend (bzw. - je nach Lotverfahren- vor dem Bestücken des Bauelements 8) wird ein Lot 5 bereitgestellt. Es handelt sich erfindungsgemäß um ein hoch- Bismut haltiges Lot 5 d.h. mit einem Anteil von zumindest 50 Gewichtsprozent Bismut. Das Bauelement 8 wird anschließend in einem Massen- oder Selektivlötverfahren verlötetet, um die sprödbrechende Lotverbindung 3 herzustellen, bspw. mittels eines Wellen- oder Reflow-Lötverfahrens.

Allen gängigen Lötverfahren ist gemein, dass bei der Prozesssteuerung während des Lötverfahrens ein in Fig. 2 näher dargestelltes Temperaturprofil angesteuert bzw. durchgefahren wird. Dabei handelt es sich um eine Temperatur- Zeit Funktion, die beschreibt, zu welchem Zeitpunkt während des Lötens das Lötgut (bspw. das Bauelement 8) und/oder das Lot 5 welche Temperatur erfahren. Beispielsweise geschieht typischerweise in einem ersten Abschnitt des Temperaturprofils ein Vorheizen, gefolgt von einem Aufheizen auf eine maximale Temperatur Tmax. Diese liegt typischerweise oberhalb der Liquidustemperatur LQ des Lots 5. Anschließend erfolgt ein gesteuertes Abkühlen d.h. mit einer definierten, eingestellten Abkühlrate dT/dt. Als Abkühlrate dT/dt wird bei einem Lötvorgang die maximale zeitliche Änderung der Temperatur während des Abkühlens bezeichnet, unmittelbar anschließend zu dem Zeitpunkt, an dem eine Liquidustemperatur LQ des Lots 5 vorliegt.

Erfindungsgemäß wird nun das hoch-Bismut haltige Lot 5 mit einer Abkühlrate dT/dt kombiniert, die größer als 6° C/s ist. Dies ist größer als im Stand der Technik üblicherweise verwendete Abkühlraten. Überraschenderweise hat sich in Untersuchungen der Anmelderin gezeigt, dass dadurch eine sprödbrechende Lotverbindung 6 erzeugt wird.

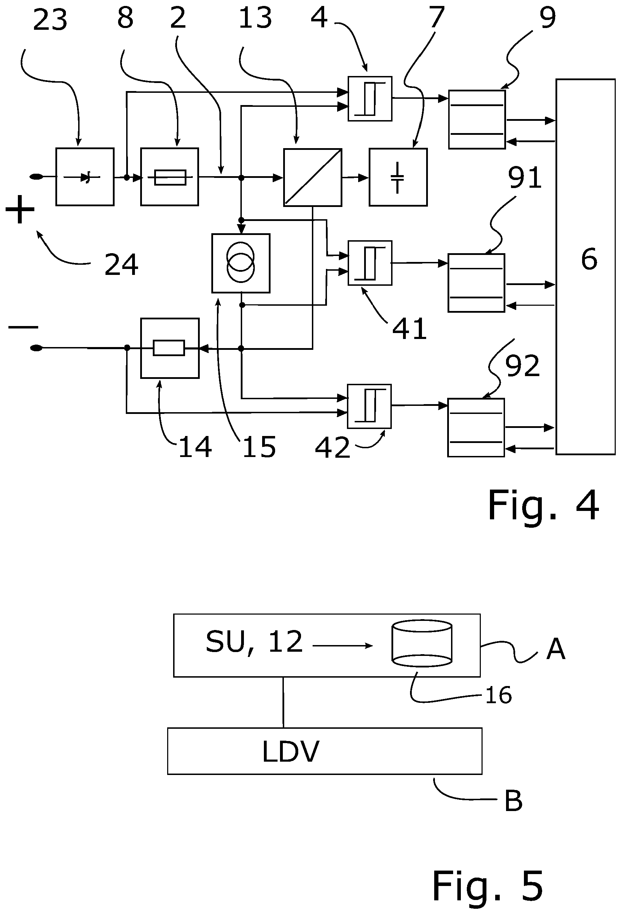

Dies ist in Fig. 3 näher dargestellt. Tritt (bspw. durch Schläge, Vibrationen, oder thermomechanische Verwindung durch Temperaturgradienten o.ä.) eine mechanische Überbelastung des elektronischen Geräts 11 auf, wirkt eine zu große Kraft F auf die Lotverbindung 3. Dies führt dies zu einem teilweisen Sprödbruch SB in der Lotverbindung 3. Dieser teilweise Sprödbruch SB wird dabei mittels einem, insb. kurzzeitigen, Spannungs- und/oder Stromunterbruch in einer Fangschaltung (siehe Schaltbild in Fig. 4) durch die Schaltungsanordnung 1 selbst detektiert. Die Schaltungsanordnung 1 dient daher als ein Warnsystem, das angezeigt, dass das Gerät der mechanischen Überbelastung ausgesetzt war.

Im Rahmen der Erfindung herrschen keinerlei Einschränkung daran, in welchem Pfad der Schaltungsanordnung 1 die sprödbrechende Lotverbindung 3 angeordnet ist. Bspw. ist das Bauelement 8 als eine Sicherung mit einem Übergangswiderstand < 1 Ohm ausgebildet. Ähnlich wie in Fig. 1 a, b gezeigt sind die Lötstellen, mittels derer der die Sicherung auf die Leiterplatte gelötet ist, als die sprödbrechende Lotverbindung 3 ausgeführt. Es können aber auch Lötstellen innerhalb der Sicherung selbst als die sprödbrechende Lotverbindung 3 ausgeführt sein. Weiterhin kann die sprödbrechende Lotverbindung 3 in einem Pfad der Schaltungsanordnung 1 angeordnet sein, welcher nicht mit einem speziellen Bauelement 8, sondern bspw. nur mit einer Leiterbahn etc. assoziiert ist.

Durch den teilweisen Sprödbruch SB liegen die Bruchflächen des sprödgebrochenen Bereichs der Lotverbindung 3, anschließend zu dem Spannungs- und/oder Stromunterbruch SU wieder in engem Kontakt miteinander. Tritt eine Kaltverschweißung der Bruchflächen auf, normalisiert sich ein durch die Lotverbindung 3 mitbestimmte Übergangswiderstand nach der zeitweiligen Überbeanspruchung wieder auf einen Normalwert, so dass eine mit einer mechanischen Überbelastung assoziierter Spannungs- und/oder Stromunterbruch SU auch mehrmals feststellbar ist.

In Fig. 4 ist ein Schaltbild für eine Ausgestaltung einer Schaltungsanordnung 1 gezeigt, mittels derer ein Spannungs- und/oder Stromunterbruch SU in dem Pfad 2 mit der sprödbrechenden Lotverbindung 3 (hier: dem Bauelement 8, was als ein Widerstandselement, bspw. eine Sicherung, ausgebildet ist) detektierbar ist. Bevorzugt ist der Spannungs- und/oder Stromunterbruch SU auf zumindest zwei voneinander im Wesentlichen unabhängige, unterschiedliche Wege (hier: drei) feststellbar.

Erster Weg: Eine kurzzeitige Spannungserhöhung über dem Bauelement 8 durch den höchstens zeitweiligen Spannungsunterbruch SU wird bspw. mittels eines ersten Komparatorelements 4 erfasst, wobei das erste Komparatorelement 4 eine Komparatorspannung bereitstellt. Stellt das erste Komparatorelement 4 den Spannungs- und/oder Stromunterbruch SU fest, wird ein erster Flip-Flop 9 durch das Komparatorelement 4 umgeschaltet. Der erste Flip-Flop 9 teilt sein Umschalten an einen damit verbundenen Mikrokontroller 6 mit, welcher dadurch den Spannungsunterbruch SU in dem Pfad 2 erfasst und mitschreibt, entweder in einem eigenen Speicherbaustein des Mikrokontrollers 6, oder in einer mit der Elektronikeinheit 10 verbundenen Speichereinheit 16. Nach dem Erfassen des Spannungs- und/oder Stromunterbruch SU durch den Mikrokontroller 6 setzt dieser den ersten Flip-Flop 9 wieder auf seinen Ausgangswert zurück, so dass ein zukünftiger Spannungs- und/oder Stromunterbruch SU in dem Pfad 2 erneut feststellbar ist.

Zweiter Weg: Mittels einer Stromsenke 15 und eines zweiten Komparatorelements 41 wird der Spannungs- und/oder Stromunterbruch SU erfasst, wobei das zweite Komparatorelement 41 eine Komparatorspannung bereitstellt. Ähnlich wie im ersten Weg wird auch im zweiten Weg ein zweites Flip Flop 91 gesetzt, mittels dessen der Spannungs- und/oder Stromunterbruch SU durch den Mikrokontroller 6 erfasst wird.

Dritter Weg: Der Fall eines höchstens zeitweiligen Stromunterbruchs wird mittels eines Komparatorstroms eines dritten Komparatorelements 42 und eines damit verbundenen Messwiderstands 14 detektiert. In diesem Fall wird ein drittes Flip Flop 92 gesetzt, um den Spannungs- und/oder Stromunterbruch SU an den Mikrokontroller 6 zu übermitteln.

Eingangs der Schaltbilds, direkt anschließend an eine Spannungsversorgung 24, ist zudem noch eine Messdiode 23 angeordnet, welche dem Verpolschutz dient.

Unabhängig von den vorstehend genannten Wegen wird in dem Fall des Spannungs- und/oder Stromunterbruch SU für dessen Dauer eine Betriebsspannung für das elektronische Gerät 11 bereitgestellt. Dies durch einen Kondensator 7, der mit einen Spannungsregler 13 in der Schaltungsanordnung 1 verschaltet ist. Dadurch kann ausfallsicher die mechanische Überbelastung durch den Mikrokontroller 6 erfasst werden, d.h. ohne dass der Betrieb des elektronisches Gerät 11 für die Dauer des Spannungs- und/oder Stromunterbruch SU unterbrochen wäre.

Ein Spannungs- und/oder Stromunterbruch SU mit einer Dauer von zumindest 3,5 nsec ist mittels moderner Komparatorelemente 4,41,42 ohne Weiteres feststellbar, z.B. mit einem Komparator des Typs NCP22.

Fig. 5. zeigt Schritte des erfindungsgemäßen Verfahrens zum Feststellen einer höchstens zeitweiligen mechanischen Überbeanspruchung des elektronischen Geräts 11. In einem ersten Schritt A) wird wie vorstehend ausgeführt mittels des Spannungs- und/oder Stromunterbruch SU das Auftreten einer mechanischen Überbelastung festgestellt.

Bevorzugt wird das Auftreten der mechanischen Überbelastung in einer Speichereinheit 16 abgespeichert, zusammen mit einem Zeitstempel 12, durch den der Zeitpunkt des Auftretens eindeutig markiert ist. Wie vorstehend erwähnt kann die Speichereinheit Teil der Elektronikeinheit 10 und damit des elektronischen Geräts 11 selbst sein.

Alternativ kann die Speichereinheit 16 auch in einer übergeordneten Einheit zugeordnet sein, an die das elektronisches Gerät 11 mittels einer Kommunikationsverbindung angeschlossen ist. Bei der übergeordneten Einheit handelt es sich bspw. um eine übergeordnete Steuerungseinheit, bspw. ein Prozessleitsystem mit einem Rechner oder um eine speicherprogrammierte Steuerungseinheit (SPS).

Bei der Kommunikationsverbindung handelt es sich bspw. um eine drahtgebundene Kommunikationsverbindung bspw. um eine analoge Messübertragungsstrecke, insb. nach dem 4-20mA Standard, oder um einen drahtgebundenen Feldbus der Automatisierungstechnik, bspw. Foundation Fieldbus, Profibus PA, Profibus DP, HART, CANBus. Es kann sich aber auch um eine Kommunikationsverbindung eines modernen industriellen Kommunikationsnetzwerks, bspw. einen "Industrial Ethernet"-Feldbus, insbesondere Profinet, HART-IP oder Ethernet/IP oder eines aus dem Kommunikationsbereich bekanntes Kommunikationsnetzwerk, bspw. Ethernet nach dem TCP/IP-Protokoll, handeln.

Für den Fall, dass die Kommunikationsverbindung drahtlos ist, kann es sich zum Beispiel um ein Bluetooth, ZigBee-, WLAN-, GSM-, LTE-, UMTS-Kommunikationsnetzwerk oder aber auch eine drahtlose Version eines Feldbusses, insbesondere 802.15.4 basierte Standards wie WirelessHART handeln.

In einem zweiten Schritt B) wird auf Basis der gespeicherten Spannungs- und/oder Stromunterbrüche SU und ggf. der Zeitstempel 12 eine Lebensdauervorhersage LDV für das elektronische Gerät 11 erstellt und/oder angepasst. Dabei wird die Anzahl der Spannungs- und/oder Stromunterbrüche SU, aber auch deren Zeitpunkt berücksichtigt.

Mittels der gespeicherten Spannungs- und/oder Stromunterbrüche SU und/oder der angepassten Lebensdauervorhersage LDV ist im Falle eines dauerhaften Ausfalls des elektronischen Geräts 11 dieser gegebenenfalls auf die durch das elektronische Gerät 11 erfahrenen mechanischen Überbeanspruchungen zurückführbar. Der Ausfall wird dabei nicht durch den teilweisen Sprödbruch SB der Lotverbindung 3 verursacht, sondern durch weitere Beschädigungen an dem elektronische Gerät 11, welche aber auch auf die mechanische Überbeanspruchung, welche den Sprödbruch verursacht hat, zurückführbar sind. Der mit dem Spannungs- und/oder Stromunterbruch SU assoziierte Sprödbruch SB dient im Rahmen der Erfindung also nur dazu, das Auftreten der mechanischen Überbelastung verlässlich zu detektieren.

Das erfindungsgemäße Verfahren erleichtert daher die Schadensabwicklung zwischen dem Hersteller und einem Anwender des elektronischen Gerät 11, welcher dieses mechanisch überbeansprucht hat.

Die Schritte des Verfahrens werden durch das elektronische Gerät 11 selbst, oder aber in Kombination mit der vorstehend erwähnten übergeordneten Einheit ausgeführt.

Bevorzugt ist das elektronische Gerät 11 als ein Feldgerät der Automatisierungstechnik ausgebildet. Ein derartiges elektronisches Gerät 11 ist in Fig. 6 näher dargestellt.

Das Feldgerät 11 weist eine, insbesondere zumindest zeitweise und/oder zumindest abschnittsweise mit einem Prozessmedium in Kontakt stehende Sensoreinheit 17 auf, welche der Erzeugung eines die Prozessgröße repräsentierenden, bspw. elektrischen und/oder elektronischen, Messsignals, dient.

Die in einem Transmittergehäuse 21 des Feldgeräts 11 angeordnete Elektronikeinheit 10 dient der Verarbeitung und/oder Weiterleitung von der von der Sensoreinheit 17 erzeugten Messsignale. Die Elektronikeinheit 10 umfasst eine Leiterplatte 22 mit der Schaltungsanordnung 1, die in einem Pfad die sprödbrechende Lotverbindung 3 aufweist, mittels derer die mechanische Überbelastung des Feldgeräts, bspw. in einem Messbetrieb, feststellbar ist.

Vorteilhaft ist für das Feldgerät dessen mechanische Überbelastung auch im Nachhinein feststellbar, durch Auslesen der in der Speichereinheit 16 gespeicherten erfassten Ereignisse der Spannungs- und/oder Stromunterbrüche SU.

In der in Fig. 6 gezeigten Ausgestaltung weist das Feldgerät 11 eine weitere, als Anzeige-/Eingabeeinheit 20 dienende, Elektronikeinheit 10a auf, mit einem darauf montierten (Touch-)Display. Für den Fall, dass das Feldgerät 11 mehrere Elektronikeinheiten 10,10a, ... aufweist, ist es selbstverständlich möglich, dass die sprödbrechende Lotverbindung 3, mittels der eine mechanische Überbeanspruchung feststellbar ist, in einer oder beider der Elektronikeinheiten 10, 10a eingesetzt wird.

### Bezugszeichen und Symbole

- 1: Schaltungsanordnung
- 2: Pfad
- 3: Lotverbindung
- 4,41,42: Komparatorelement
- 5: Lot
- 6: Mikrokontroller
- 7: Kondensator
- 8: Bauelement
- 9,91,92: Flip-Flop
- 10, 10a: Elektronikeinheit
- 11: Elektronisches Gerät
- 12: Zeitstempel
- 13: Spannungsregler
- 14: Messwiderstand
- 15: Stromsenke
- 16: Speichereinheit
- 17: Sensoreinheit
- 20: Anzeige-/Eingabeeinheit
- 21: Transmittergehäuse
- 22: Leiterplatte
- 23: Messdiode
- SU: Spannungs- und/oder Stromunterbruch
- SB: Sprödbruch
- dT/dt: Abkühlrate
- LQ: Liquidustemperatur
- Tmax: maximale Temperatur
- F: Kraft

## Patentansprüche

1. Elektronisches Gerät aufweisend eine Schaltungsanordnung (1),
wobei die Schaltungsanordnung (1) in einem elektrisch leitenden Pfad (2) der Schaltungsanordnung eine sprödbrechende Lotverbindung (3) aufweist,
und wobei die Schaltungsanordnung (1) dazu ausgestaltet ist, einen höchstens zeitweiligen Spannungs- und/oder Stromunterbruch (SU) in dem Pfad (2) zu detektieren und einem höchstens teilweisen Sprödbruch (SB) der sprödbrechenden Lotverbindung (3) zuzuordnen, welcher Sprödbruch (SB) durch eine höchstens zeitweilige mechanische Überbeanspruchung des elektronischen Geräts verursacht ist,
so dass anhand der Schaltungsanordnung (1) die höchstens zeitweilige mechanische Überbeanspruchung des elektronischen Geräts feststellbar ist,
wobei die sprödbrechende Lotverbindung mittels eines Lötprozesses umfassend die folgenden Schritte hergestellt ist:
- Bereitstellen von Lot (5) welches Lot Bismut (Bi) mit einem Anteil von zumindest 50 Gewichtsprozent aufweist;
- Aufschmelzen des Lots (5), bei welchem Aufschmelzen das Lot (5) auf eine maximale Temperatur (Tmax) gebracht wird;
- Anschließendes Abkühlen des Lots (5), bei welchem Abkühlen das Lot (5) erstarrt, so dass die Lotverbindung (3) gebildet wird, wobei das Abkühlen mit einer Abkühlrate (dT/dt) erfolgt, welche Abkühlrate (dT/dt) größer als 10° C/s ist.

2. Elektronisches Gerät nach Anspruch 1,
wobei das bereitgestellte Lot (5) Zinn (Sn) mit einem Anteil von zumindest 40 Gewichtsprozent aufweist
und/oder Silber (Ag) mit einem Anteil von höchstens 2 Gewichtsprozent aufweist.

3. Elektronisches Gerät nach Anspruch 2 oder 3, wobei die Abkühlrate (dT/dt) kleiner als 50°C/s ist.

4. Elektronisches Gerät nach zumindest einem der vorherigen Ansprüche,
wobei die Schaltungsanordnung zur Detektion des höchstens zeitweiligen Spannungs- und/oder Stromunterbruchs (SU) zumindest ein Komparatorelement (4) aufweist.

5. Elektronisches Gerät nach zumindest einem der vorherigen Ansprüche,
wobei die Schaltungsanordnung einen Mikrokontroller (6) aufweist, welcher Mikrokontroller (6) derart mit dem/den Komparatorelement/en (4) verschaltet ist,
dass das/die Komparatorelement/e (4) einen detektierten, höchstens zeitweiligen Spannungs- und/oder Stromunterbruch (SU) an den Mikrokontroller (6) übermittelt/en.

6. Elektronisches Gerät nach zumindest einem der vorherigen Ansprüche,
wobei die Schaltungsanordnung einen Kondensator (7) aufweist, der für den Fall eines höchstens zeitweiligen Spannungs- und/oder Stromunterbruchs (SU) für die Zeitspanne des Unterbruchs (SU) zur Überbrückung des Unterbruchs (SU) eine in dem Kondensator (7) gespeicherte Spannung als Betriebsspannung für das elektronische Gerät bereitstellt.

7. Elektronisches Gerät nach zumindest einem der vorherigen Ansprüche, wobei die höchstens zeitweilige Spannungs- und/oder Stromunterbruchs (SU) für eine Dauer von zumindest 3,5 ns (Nanosekunden) vorliegt.

8. Elektronisches Gerät nach zumindest einem der vorherigen Ansprüche, wobei der höchstens zeitweilige Spannungs- und/oder Stromunterbruchs (SU) für eine Dauer von maximal 20 ms (Millisekunden) vorliegt.

9. Elektronisches Gerät (11) nach zumindest einem der vorherigen Ansprüche,
wobei es sich um bei dem elektronischen Gerät (11) um ein Feldgerät der Automatisierungstechnik mit zumindest einer Elektronikeinheit (10) handelt, und wobei die Elektronikeinheit (10) die Schaltungsanordnung (1) aufweist.

10. Verfahren zum Feststellen einer mechanischen Überbeanspruchung eines elektronischen Geräts (11) nach zumindest einem der Ansprüche 1 bis 9,
umfassend den Schritt:
- Feststellen einer höchstens zeitweiligen mechanischen Überbeanspruchung des elektronischen Geräts (11), für den Fall, dass eine höchstens zeitweiliger Spannungs- und/oder Stromunterbruch (SU) in einem Pfad (2) der Schaltungsanordnung (1) detektiert wird, der einem höchstens teilweisen Sprödbruch (SB) der sprödbrechenden Lotverbindung (3) zuordenbar ist.

11. Verfahren nach Anspruch 10, umfassend den Schritt:
- Erfassen eines Zeitpunkts, an welchem die Überbeanspruchung festgestellt wird;
- Abspeichern einer festgestellten Überbeanspruchung zusammen mit einem Zeitstempel (12), welcher Zeitstempel (12) den erfassten Zeitpunkt der Überbeanspruchung markiert.

12. Verfahren nach Anspruch 10 oder 11,
wobei die mechanische Überbeanspruchung wiederkehrend festgestellt und abgespeichert wird.

13. Verfahren nach zumindest einem der Ansprüche 10 bis 12,
umfassend den Schritt:
Erstellen und/oder Anpassen einer Lebensdauervorhersage (LDV) für das elektronische Gerät (11), basierend auf der/den festgestellten mechanischen Überbeanspruchung/en,
wobei bei der Lebensdauervorhersage (LDV) zumindest eines der folgenden berücksichtigt wird:
- eine Anzahl der festgestellten mechanischen Überbeanspruchungen;
- den/die Zeitpunkt/e der festgestellten mechanischen Überbeanspruchung/en.

## Claims

1. An electronic device having a circuit configuration (1),
wherein the circuit configuration (1) has a brittle solder connection (3) in an electrically conductive path (2) of the circuit configuration,
and wherein the circuit configuration (1) is configured to detect an at most temporary voltage and/or power outage (SU) in the path (2) and to attribute it to an at most partial brittle failure (SB) of the brittle solder connection (3), said brittle failure (SB) being caused by an at most temporary mechanical overload of the electronic device
so that the at most temporary mechanical overload of the electronic device can be detected using the circuit configuration (1),
wherein the brittle solder connection is established by means of a soldering process comprising the following steps:
- Supplying solder (5), said solder containing at least 50 percent by weight of bismuth (Bi);
- Melting the solder (5), during which melting process the solder (5) is brought to a maximum temperature (Tmax);
- Subsequently cooling the solder (5), during which cooling process the solder (5) sets to form the solder connection (3), wherein cooling takes place at a cooling rate (dT/dt), said cooling rate (dT/dt) being faster than 10 °C/s.

2. The electronic device as claimed in claim 1,
wherein the solder (5) supplied contains at least 40 percent by weight of tin (Sn) and/or a maximum of 2 percent by weight of silver (Ag).

3. The electronic device as claimed in claim 2 or 3,
wherein the cooling rate (dT/dt) is slower than 50 °C/s.

4. The electronic device as claimed in at least one of the preceding claims,
wherein the circuit configuration for detecting the at most temporary voltage and/or power outage (SU) has at least one comparator element (4).

5. The electronic device as claimed in at least one of the preceding claims,
wherein the circuit configuration has a microcontroller (6), said microcontroller (6) being connected to the comparator element(s) (4) in such a way that
the comparator element(s) (4) transmits/transmit a detected, at most temporary voltage and/or power outage (SU) to the microcontroller (6).

6. The electronic device as claimed in at least one of the preceding claims,
wherein the circuit configuration has capacitor (7), which provides a voltage stored in the capacitor (7) as operating voltage for the electronic device for the duration of the outage (SU) to bridge the outage (SU) in the event of an at most temporary voltage and/or power outage (SU).

7. The electronic device as claimed in at least one of the preceding claims,
wherein the at most temporary voltage and/or power outage (SU) occurs for a duration of at least 3.5 ns (nanoseconds).

8. The electronic device as claimed in at least one of the preceding claims,
wherein the at most temporary voltage and/or power outage (SU) occurs for a duration of at most 20 ms (milliseconds).

9. The electronic device (11) as claimed in at least one of the preceding claims,
wherein the electronic device (11) is an automation technology field device with at least one electronic unit (10), and wherein the electronic unit (10) has the circuit configuration (1).

10. A method for detecting a mechanical overload of an electronic device (11) as claimed in at least one of claims 1 to 9, comprising the step:
- Detecting an at most temporary mechanical overload of the electronic device (11) for the event that an at most temporary voltage and/or power outage (SU) is detected in a path (2) of the circuit configuration (1), which can be attributed to an at most partial brittle failure (SB) of the brittle solder connection (3).

11. The method as claimed in claim 10, comprising the step:
- Recording a time point at which the overload is detected;
- Saving a detected overload together with a timestamp (12), said timestamp (12) representing the recorded time point of the overload.

12. The method as claimed in claim 10 or 11,
wherein the mechanical overload is detected and saved on a recurring basis.

13. The method as claimed in at least one of claims 10 to 12,
comprising the step:
Creating and/or adapting a service life prediction (LDV) for the electronic device (11), based on the detected mechanical overload(s),
wherein the service life prediction (LDV) considers at least one of the following:
- A number of detected mechanical overloads;
- The time point(s) of the detected mechanical overload(s).

## Revendications

1. Appareil électronique comportant un circuit (1), ledit circuit (1) comportant, dans un chemin électriquement conducteur (2) du circuit, une connexion soudée à rupture fragile (3), et le circuit (1) étant conçu pour détecter une interruption de tension et/ou de courant (SU) d'une durée maximale de deux secondes dans le chemin (2) et pour l'attribuer à une rupture de fragilité (SB) au maximum partielle de la connexion soudée à rupture fragile (3), laquelle rupture de fragilité (SB) est causée par une sollicitation mécanique excessive au maximum temporaire de l'appareil électronique,
de sorte que la sollicitation mécanique excessive au maximum temporaire de l'appareil électronique peut être détectée à l'aide du circuit (1), la connexion soudée à rupture fragile étant réalisée au moyen d'un processus de soudage comprenant les étapes suivantes :
- Fourniture d'une soudure (5), laquelle soudure contient du bismuth (Bi) dans une proportion d'au moins 50 % en poids ;
- Fusion de la soudure (5), fusion lors de laquelle la soudure (5) est portée à une température maximale (Tmax) ;
- Refroidissement consécutif de la soudure (5), refroidissement au cours duquel la soudure (5) se solidifie, de sorte que la connexion soudée (3) est formée, le refroidissement s'effectuant à une vitesse de refroidissement (dT/dt) supérieure à 10 °C/s.

2. Appareil électronique selon la revendication 1,
pour lequel la soudure (5) fournie contient de l'étain (Sn) dans une proportion d'au moins 40 % en poids
et/ou de l'argent (Ag) dans une proportion d'au plus 2 % en poids.

3. Appareil électronique selon la revendication 2 ou 3, pour lequel le taux de refroidissement (dT/dt) est inférieur à 50 °C/s.

4. Appareil électronique selon au moins l'une des revendications précédentes, pour lequel le circuit destiné à détecter l'interruption de tension et/ou de courant (SU) au maximum temporaire comprend au moins un élément comparateur (4).

5. Appareil électronique selon au moins l'une des revendications précédentes, pour lequel le circuit comprend un microcontrôleur (6), lequel microcontrôleur (6) est connecté à l'élément/aux éléments comparateurs (4) de telle sorte que le ou les éléments comparateurs (4) transmettent au microcontrôleur (6) une interruption de tension et/ou de courant (SU) détectée, laquelle interruption est au maximum temporaire.

6. Appareil électronique selon au moins l'une des revendications précédentes, pour lequel le circuit comprend un condensateur (7) qui, en cas d'interruption au maximum temporaire de la tension et/ou du courant (SU), fournit la tension stockée dans le condensateur (7) comme tension de service pour l'appareil électronique.

7. Appareil électronique selon au moins l'une des revendications précédentes, pour lequel l'interruption de tension et/ou de courant (SU) au maximum temporaire est présente pendant une durée d'au moins 3,5 ns (nanosecondes).

8. Appareil électronique selon au moins l'une des revendications précédentes, pour lequel l'interruption de tension et/ou de courant (SU) au maximum temporaire dure au maximum 20 ms (millisecondes).

9. Appareil électronique selon au moins l'une des revendications précédentes, l'appareil électronique (11) étant un appareil de terrain de la technique d'automatisation comportant au moins une unité électronique (10), et
pour lequel l'unité électronique (10) comporte le circuit (1).

10. Procédé destiné à détecter une sollicitation mécanique excessive d'un appareil électronique (11) selon au moins l'une des revendications 1 à 9, lequel procédé comprend l'étape suivante :
- Détection d'une sollicitation mécanique excessive au maximum temporaire de l'appareil électronique (11) dans le cas où une interruption de tension et/ou de courant (SU) au maximum temporaire est détectée dans un chemin (2) du circuit (1), laquelle interruption peut être attribuée à une rupture de fragilité (SB) tout au plus partielle de la connexion soudée à rupture fragile (3).

11. Procédé selon la revendication 10,
lequel procédé comprend les étapes suivantes :
- Détection d'un moment auquel la sollicitation excessive est constatée ;
- Enregistrement d'une sollicitation excessive constatée avec un horodatage (12), lequel horodatage (12) marque le moment détecté de la sollicitation excessive.

12. Procédé selon la revendication 10 ou 11,
pour lequel la sollicitation mécanique excessive est détectée et enregistrée de manière récurrente.

13. Procédé selon au moins l'une des revendications 10 à 12,
comprenant l'étape suivante :
Création et/ou adaptation d'une prévision de durée de vie (LDV) pour l'appareil électronique (11) sur la base de la ou des surcharges mécaniques détectées,
la prévision de durée de vie (LDV) tenant compte d'au moins l'un des éléments suivants :
- un nombre de contraintes mécaniques excessives détectées ;
- le ou les moments de la ou des contraintes mécaniques excessives détectées.
